(19) Europäisches Patentamt
European Patent Office
Office européen des brevets

(11) **EP 3 910 360 B1**

(12) **EUROPÄISCHE PATENTSCHRIFT**

(45) Veröffentlichungstag und Bekanntmachung des Hinweises auf die Patenterteilung:
**06.08.2025   Patentblatt 2025/32**

(21) Anmeldenummer: **20174639.3**

(22) Anmeldetag: **14.05.2020**

(51) Internationale Patentklassifikation (IPC):
**G01R 35/00** $^{(2006.01)}$   **G01D 3/02** $^{(2006.01)}$
**G01D 3/036** $^{(2006.01)}$   G01R 15/04 $^{(2006.01)}$
G01R 15/08 $^{(2006.01)}$   G01R 19/32 $^{(2006.01)}$
G01R 21/14 $^{(2006.01)}$

(52) Gemeinsame Patentklassifikation (CPC):
**G01R 35/00; G01D 3/022; G01D 3/0365;**
G01R 15/04; G01R 15/08; G01R 19/32; G01R 21/14

(54) **ANORDNUNG MIT EINER MESSEINRICHTUNG UND VERFAHREN ZU DEREN BETRIEB**

ASSEMBLY WITH A MEASURING DEVICE AND METHOD FOR OPERATING THE SAME

AGENCEMENT DOTÉ D'UN AGENCEMENT DE MESURE ET SON PROCÉDÉ DE FONCTIONNEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.11.2021   Patentblatt 2021/46**

(73) Patentinhaber: **Siemens Aktiengesellschaft**
**80333 München (DE)**

(72) Erfinder: **Spangler, Markus**
**90542 Eckental (DE)**

(74) Vertreter: **Siemens Patent Attorneys**
**Postfach 22 16 34**
**80506 München (DE)**

(56) Entgegenhaltungen:
DE-A1- 102016 104 874   DE-A1- 102017 213 040
DE-A1- 102019 212 943   US-A1- 2003 042 886
US-A1- 2016 209 446   US-B2- 7 660 682

**Beschreibung**

Die Erfindung bezieht sich auf Anordnungen mit Messeinrichtungen, die geeignet sind, ein von einer Messeinheit geliefertes Ausgangssignal, das eine Betriebsgröße einer technischen Anlage beschreibt, zu messen und einen Messwert zu erzeugen. Außerdem bezieht sich die Erfindung auf Verfahren zum Betrieb derartiger Anordnungen.

In Mittel- und Hochspannungsnetzen werden typischerweise Ströme mittels Messeinheiten in Form von Stromwandler/- sensoren gemessen. Zum einen werden Ströme (mit einer geringeren Genauigkeit) gemessen, um damit Schutzgeräte mit Betriebswerten zu versorgen; zum anderen möchten Netzbetreiber vermehrt genaue Strommessungen (zusammen mit Spannungsmessungen) zur Energie-/Leistungsberechnung nutzen. Zukünftig kommen auch vermehrt (Weitbereichs)-Kleinsignalwandler zum Einsatz. Aufgrund gestiegenen Kostendrucks ist es ein Ziel, für beide Anwendungen den gleichen bzw. baugleiche Wandler/- Sensoren einsetzen zu können. Damit könnten Komponentenkosten, Verdrahtungsaufwand und Betriebskosten reduziert werden.

Weiterhin bestehen auch bei reinen Schutzgeräteanwendungen immer höhere Anforderungen an die Genauigkeit der Strommessung. Insbesondere treten bei kleineren Betriebsströmen höhere Ungenauigkeiten sowohl bei der Amplitude als auch bei der Phasenlage auf. Dies führt zu Abweichungen bei Leistungsmessungen und ggf. zu Ungenauigkeiten bei verschiedenen Schutzfunktionen.

Der Erfindung liegt die Aufgabe zugrunde, Anordnungen der beschriebenen Art hinsichtlich der Anforderungen an die Arbeitsgenauigkeit angeschlossener Messeinheiten zu verbessern.

Diese Aufgabe wird erfindungsgemäß durch eine Anordnung mit den Merkmalen gemäß Patentanspruch 1 und durch ein Verfahren gemäß Anspruch 12 gelöst. Vorteilhafte Ausgestaltungen der erfindungsgemäßen Anordnung sind in Unteransprüchen angegeben.

Danach ist erfindungsgemäß vorgesehen, dass die Anordnung eine Korrektureinheit aufweist, die dazu ausgestaltet ist, den von der Messeinrichtung erzeugten Messwert gemäß einer messeinheitsindividuell zugeordneten Korrekturanweisung zu korrigieren und einen korrigierten Messwert zu erzeugen, wobei das Maß der Korrektur gemäß der messeinheitsindividuellen Korrekturanweisung von dem von der Messeinrichtung erzeugten Messwert und/oder von der Höhe einer anderen Betriebsgröße der technischen Anlage abhängt.

Ein wesentlicher Vorteil der erfindungsgemäßen Anordnung ist darin zu sehen, dass durch die messeinheitsindividuelle und betriebsgrößenabhängige Korrektur auf der Basis der messeinheitsindividuell zugeordneten sowie betriebsgrößenabhängigen Korrekturanweisung etwaige systematische Fehler der Messeinheit, die messeinheitsindividuell von einer oder mehreren Betriebsgrößen der Anlage abhängen, korrigiert bzw. "herausgerechnet" werden können. Die resultierende Messgenauigkeit lässt sich somit erhöhen. Alternativ kann der Einsatz weniger genauer Messeinheiten erwogen werden, wenn sich durch die messeinheitsindividuelle Korrektur auch mit den weniger genauen Messeinheiten bereits vorgegebene Genauigkeitsgrenzen einhalten lassen; dadurch lassen sich Kosten reduzieren.

Auch ist es in vorteilhafter Weise möglich, mit den korrigierten Messwerten abhängige Messwerte zu bilden, beispielsweise Summenwerte, und dies mit einer Genauigkeit, die für viele Anwendungen aufgrund der erfindungsgemäß vorgenommenen Korrektur ausreichend ist, aber ohne die Korrektur nicht ausreichend wäre und den Einsatz besserer bzw. genauerer Messeinheiten oder zusätzlicher Messeinheiten (z. **B.** Summenstromsensoren) erforderlich machen würde.

Bei der oder den Messeinheiten handelt es sich vorzugsweise um analoge Messeinheiten, die analoge Ausgangssignale erzeugen, wie analoge Messsensoren oder analoge Messwandler.

Erfindungsgemäß wird die messeinheitsindividuelle Korrekturanweisung anhand zumindest einer für die jeweilige Messeinheit gemessenen Fehlerkurve oder Fehlerkurvenschar ermittelt, die einen von der Messeinheit in dem Ausgangssignal hervorgerufenen Fehler - vorzugsweise über den gesamten Arbeits- bzw. Messbereich der Messeinheit - in Abhängigkeit von einer oder mehreren Betriebsgrößen der Anlage quantifizieren.

Durch die Korrektur mittels der Korrekturanweisung wird vorzugsweise der Fehler der Messeinheit kompensiert oder zumindest reduziert.

Die Korrekturanweisung enthält eine zu der gemessenen Fehlerkurve oder Fehlerkurvenschar inverse oder komplementäre Funktion oder Funktionenschar oder wird durch zumindest eine solche inverse oder komplementäre Funktion oder Funktionenschar gebildet.

Die Funktion kann im Falle einer Abhängigkeit von nur einer Betriebsgröße eine eindimensionale Funktion und im Falle einer Abhängigkeit von zwei oder mehr Betriebsgrößen eine zwei- oder mehrdimensionale Funktion sein.

Die Fehlerkurve wird vorzugsweise mittels eines Referenzmessgeräts ermittelt, das eine bessere Genauigkeitsklasse aufweist als die Messeinheit, für die die Korrekturanweisung ermittelt werden soll.

Bei einer als vorteilhaft angesehenen Variante ist vorgesehen, dass es sich bei der oder den Messeinheiten oder zumindest bei einer der Messeinheiten um einen analogen Stromwandler handelt, der einen zu messenden Strom erfasst und als Ausgangssignal einen kleineren, vorzugsweise dazu proportionalen Strom ausgibt. Ist der zu messende Strom sinusförmig, so ist der kleinere Strom also vorzugsweise ebenfalls sinusförmig und mit dem zu messenden Strom - von Wandlerfehlern abgesehen - in Phase.

Bei einer anderen als vorteilhaft angesehenen Variante ist vorgesehen, dass es sich bei der oder den Messeinheiten oder zumindest bei einer der Messeinheiten um einen analogen Stromsensor handelt, der einen zu messenden Strom erfasst und als Ausgangssignal eine Spannung, vorzugsweise eine zum Strom proportionale Spannung, ausgibt. Ist der zu messende Strom sinusförmig, so ist die Spannung also vorzugsweise ebenfalls sinusförmig und mit dem zu messenden Strom - von Sensorfehlern abgesehen - in Phase.

Bei einer wiederum anderen als vorteilhaft angesehenen Variante ist vorgesehen, dass es sich bei der oder den Messeinheiten oder zumindest bei einer der Messeinheiten um einen analogen Spannungssensor handelt, der eine zu messende Spannung erfasst und als Ausgangssignal eine kleinere Spannung, vorzugsweise eine zur zu messenden Spannung proportionale Spannung, ausgibt. Ist die zu messende Spannung sinusförmig, so ist die kleinere Spannung also vorzugsweise ebenfalls sinusförmig und mit der zu messenden Spannung - von Sensorfehlern abgesehen - in Phase.

Die Messeinrichtung ist somit vorzugsweise zum Verarbeiten eines analogen Ausgangssignals einer analogen Messeinheit ausgestaltet ist erzeugt mit dem analogen Ausgangssignal den Messwert.

Die Anordnung bildet ein Schutz- oder Messgerät zum Anschluss an eine analoge Messeinheit einer Hochspannungsanlage (Spannung ab 50 KV), einer Mittelspannungsanlage (Spannung zwischen 1 kV und 50 kV) oder einer Niederspannungsanlage (Spannung zwischen 100 V und 1 kV) oder umfasst ein solches Schutz- oder Messgerät vorzugsweise zumindest auch. Der korrigierte Messwert beschreibt in diesem Falle einen elektrischen Betriebszustand der Hoch-, Mittel- oder Niederspannungsanlage.

Die Messeinheit ist vorzugsweise ein Stromwandler, der eine Spule, insbesondere eine eisenfreie oder eisenbehaftete Spule, umfasst und als analoges Ausgangssignal ein analoges Stromsignal erzeugt.

Auch ist es vorteilhaft, wenn die Messeinheit ein Spannungswandler ist, der einen Transformator, einen kapazitiven Spannungsteiler und/oder einen ohmschen Spannungsteiler umfasst und als analoges Ausgangssignal ein analoges Spannungssignal erzeugt.

Die messeinheitsindividuell zugeordnete Korrekturanweisung ist vorzugsweise in einem Speicher der Anordnung abgespeichert.

Bezüglich der Eingabe der Korrekturanweisung wird es als vorteilhaft angesehen, wenn die Anordnung eine Eingabeeinrichtung aufweist, die eine Eingabe der Korrekturanweisung als solche oder zumindest die Eingabe eines oder mehrerer Korrekturparameter, mit denen sich die Korrekturanweisung bilden lässt, aufweist. Die Korrekturparameter können beispielsweise Korrekturfaktoren für eine Mehrzahl an Referenzstrom- oder Referenzstromspannungswerten sein; die Korrektureinrichtung kann dann für zwischen den Referenzstrom- oder Referenzspannungswerten liegende Strom- oder Spannungswerte eine Interpolation durchführen, um die tatsächlich anzuwendenden Korrekturfaktoren zu ermitteln.

Die Eingabeeinrichtung umfasst vorzugsweise eine manuelle Einrichtung zur manuellen Eingabe von Korrekturanweisung und/oder Korrekturparametern. Alternativ oder zusätzlich ist vorzugsweise eine Scanneinrichtung vorhanden, die ein Einlesen der gesamten Korrekturanweisung oder zumindest das Einlesen eines oder mehrerer Korrekturparameter ermöglicht, mit denen sich die Korrekturanweisung - beispielsweise durch die angesprochene Interpolation oder durch Ermitteln einer Korrekturfunktion auf der Basis der Korrekturparameter - bilden lässt.

Die Scanneinrichtung ist vorzugsweise geeignet, QR-Codes, die die Korrekturanweisung oder zumindest ein oder mehrere Korrekturparameter enthalten, auszulesen. Die QR-Codes sind vorzugsweise zumindest auch auf den Messeinheiten angebracht, die an die Messeinrichtung angeschlossen sind.

Die Korrekturanweisung oder zumindest ein oder mehrere Korrekturparameter und/oder der entsprechende QR-Code werden vorzugsweise auf einem Sensortypenschild und einem "Routine-Testreport" zur Verfügung gestellt. Der QR-Code kann mittels eines geeigneten Lesegerätes, z. B. Smartphones, eingelesen werden und über eine geeignete "App" einem Konfigurationstool des Messgerätes/Schutzgerätes zur Verfügung gestellt werden. Im Konfigurationstool selbst kann eine halbautomatische Zuordnung zu den richtigen Parametern der jeweiligen Phase im Gerät erfolgen.

Die messeinheitsindividuell zugeordnete Korrekturanweisung sieht bevorzugt die Korrektur des von der Messeinrichtung erzeugten Messwerts unter Berücksichtigung des Betrags, des Effektivwerts und/oder der Phase des jeweiligen von der Messeinrichtung erzeugten Messwerts vor.

Die messeinheitsindividuell zugeordnete Korrekturanweisung sieht vorzugsweise auch die Korrektur des Messwerts der Messeinrichtung unter Berücksichtigung zumindest eines Umgebungsparameters, insbesondere der jeweiligen Umgebungstemperatur der Messeinheit, vor.

Bei einer ersten besonders bevorzugten Ausgestaltung ist vorgesehen, dass das Ausgangssignal ein analoges Spannungssignal ist, der von der Messeinrichtung erzeugte Messwert ein Spannungsmesswert, insbesondere ein korrigierter Amplituden- oder Effektivwert, ist und der korrigierte Messwert ein korrigierter Spannungsmesswert, insbesondere ein korrigierter Amplituden- oder Effektivwert, ist, den die Korrektureinheit bildet gemäß

$$Uk = f(Um)$$

wobei Uk den korrigierten Spannungsmesswert und Um den von der Messeinrichtung erzeugten Spannungsmesswert bezeichnet und f(Um) eine zumindest auch von dem von der Messeinrichtung erzeugten Spannungsmesswert Um abhängige Funktion ist.

Als vorteilhaft wird es angesehen, wenn gilt:

$$Uk = \frac{Um}{X + \frac{1}{C1}}$$

wobei X eine von einer Betriebsgröße der Anlage, beispielsweise dem von der Messeinrichtung erzeugten Spannungsmesswert, abhängiger Wert oder Funktion und C1 ein konstanter, vorzugsweise messeinheitsindividueller Korrekturwert, beispielsweise gemäß der Norm IEC61869-11, ist.

Als besonders vorteilhaft wird es angesehen, wenn gilt:

$$X = \frac{a1}{Um}$$

und somit

$$Uk = \frac{Um}{\frac{a1}{Um} + \frac{1}{C1}}$$

wobei a1 eine messeinheitsindividuelle Konstante ist.

Auch ist es von Vorteil, wenn die Temperatur T der Anlage berücksichtigt wird, vorzugsweise gemäß:

$$Uk = \frac{Um}{X + \frac{1}{C1}} \cdot K1(T)$$

wobei K1(T) ein von der Temperatur T abhängiger Korrekturfaktor ist.

Bei einer zweiten besonders bevorzugten Ausgestaltung ist vorgesehen, dass das Ausgangssignal ein analoges Spannungssignal ist, der von der Messeinrichtung erzeugte Messwert ein Phasenmesswert ist und der korrigierte Messwert ein korrigierter Phasenmesswert ist, den die Korrektureinheit bildet gemäß

$$\varphi uk = f(U, \varphi m)$$

wobei φuk den korrigierten Phasenmesswert und φum den von der Messeinrichtung erzeugten Phasenmesswert bezeichnet und f(U) eine zumindest auch von der Höhe des analogen Spannungssignals, insbesondere dem Amplituden- oder Effektivwert des analogen Spannungssignals, abhängige Funktion ist.

Als vorteilhaft wird es angesehen, wenn gilt:

$$\varphi uk = \varphi um + \frac{a2 \cdot K2(T)}{U} + \varphi 1$$

wobei a2 eine messeinheitsindividuelle Konstante, K2(T) ein von der Temperatur abhängiger Korrekturfaktor, U ein Amplituden- oder Effektivwert des analogen Spannungssignals und φ1 ein konstanter, vorzugsweise messeinheitsindividueller Phasenkorrekturwert, beispielsweise gemäß der Norm IEC61869-11, ist.

Bei einer dritten besonders bevorzugten Ausgestaltung ist vorgesehen, dass das Ausgangssignal ein analoges Stromsignal ist, der von der Messeinrichtung erzeugte Messwert ein Strommesswert ist und der korrigierte Messwert ein korrigierter Strommesswert ist, den die Korrektureinheit bildet gemäß

$$Ik = f(Im)$$

wobei Ik den korrigierten Strommesswert und Im den von der Messeinrichtung erzeugten Strommesswert bezeichnet und f(Im) eine zumindest auch von dem von der Messeinrichtung erzeugten Strommesswert Im abhängige Funktion ist.

Als vorteilhaft wird es angesehen, wenn gilt:

$$Ik = \frac{Im}{X + \frac{1}{C3}}$$

wobei X eine von einer Betriebsgröße der Anlage, beispielsweise dem von der Messeinrichtung erzeugten Strommesswert Im, abhängige Funktion und C3 ein konstanter, vorzugsweise messeinheitsindividueller Korrekturwert, beispielsweise gemäß der Norm IEC61869-11, ist.

Als besonders vorteilhaft wird es angesehen, wenn gilt:

$$X = \frac{a3}{Im \cdot In}$$

und somit

$$Ik = \frac{Im}{\frac{a3}{Im \cdot In} + \frac{1}{C3}}$$

wobei a3 eine messeinheitsindividuelle Konstante und In der Nennstrom der Messeinheit ist.

Auch ist es von Vorteil, wenn die Temperatur T der Anlage berücksichtigt wird, vorzugsweise gemäß:

$$Ik = \frac{Im}{\dfrac{a3}{Im \cdot In} + \dfrac{1}{C}} \cdot K2(T)$$

wobei K2(T) ein von der Temperatur abhängiger Korrekturfaktor ist.

Bei einer vierten besonders bevorzugten Ausgestaltung ist vorgesehen, dass das Ausgangssignal ein analoges Stromsignal ist, der von der Messeinrichtung erzeugte Messwert ein Phasenmesswert ist und der korrigierte Messwert ein korrigierter Phasenmesswert ist, den die Korrektureinheit bildet gemäß

$$\varphi ik = f(I, \varphi im)$$

wobei φik den korrigierten Phasenmesswert und φim den von der Messeinrichtung erzeugten Phasenmesswert bezeichnet und f(I) eine zumindest auch von der Höhe des analogen Stromsignals, insbesondere dem Amplituden- oder Effektivwert des analogen Stromsignals, abhängige Funktion ist.

Als vorteilhaft wird es angesehen, wenn gilt:

$$\varphi ik = \varphi im + \frac{a4}{Im \cdot In} + \varphi 4$$

wobei a4 eine messeinheitsindividuelle Konstante, In der Nennstrom der Messeinheit und φ4 ein konstanter Phasenkorrekturwert, beispielsweise gemäß der Norm IEC61869-11, ist.

Bezüglich der Vorteile des erfindungsgemäßen Verfahrens und bezüglich vorteilhafter Ausgestaltungen des erfindungsgemäßen Verfahrens sei auf die obigen Ausführungen im Zusammenhang mit der erfindungsgemäßen Anordnung und deren vorteilhafter Ausgestaltungen verwiesen.

Die Erfindung wird nachfolgend anhand von Ausführungsbeispielen näher erläutert; dabei zeigen beispielhaft

Fig. 1-12 beispielhaft Fehlerkurven von Messeinheiten sowie Korrekturanweisungen in Form von Korrekturfunktionen zur Messwertkorrektur und

Fig. 13-16 Ausführungsbeispiele für Anordnungen für erfindungsgemäße Anordnungen.

In den Figuren werden für identische oder vergleichbare Komponenten stets dieselben Bezugszeichen verwendet.

Messeinheiten wie Messwandler oder Messsensoren verfügen über eine spezifische Fehlerkurve für Amplitude und Phasenlage, die im Rahmen von Fertigungstoleranzen schwankt, aber sensorindividuell im Allgemeinen sehr stabil ist.

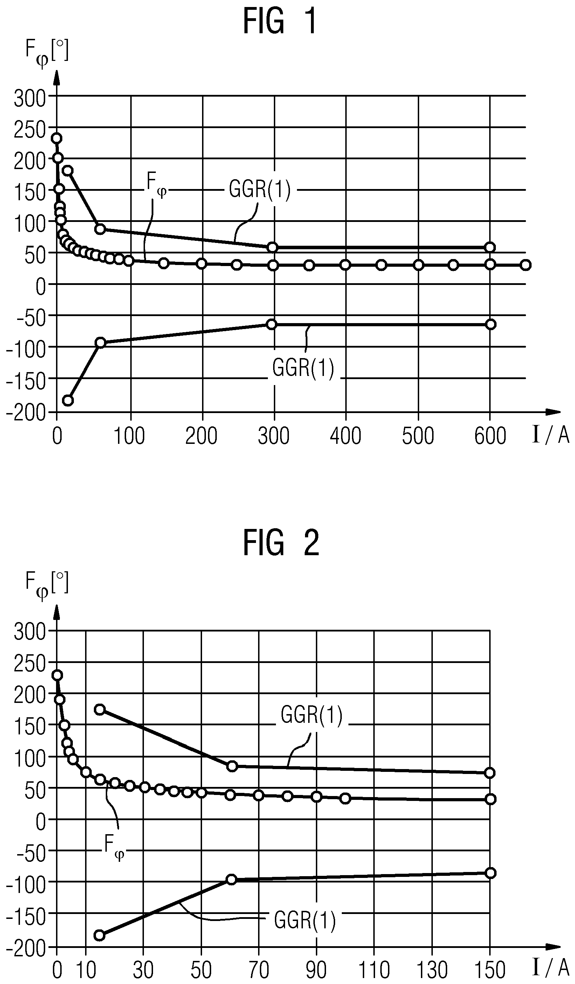

Die Figur 1 zeigt beispielhaft eine typische Fehlerkurve für den Phasenfehler Fφ der Phasenlage φ (Fehler in Abhängigkeit von der Stromhöhe I) eines Stromsensors mit einem Primärnennstrom von 300A Klasse 1 ext. 200% einschließlich der erlaubten Genauigkeitsgrenzen, die mit den Bezugszeichen GGR(1) markiert sind. Die Fehlerkurven variieren je nach Sensortypen/-lieferanten und sind im Einsatzfall durch abgewandelte/verschiedene Korrekturformeln entsprechend anzugleichen.

In den Messgeräten empfiehlt sich der Einsatz von vorgefertigten Formeln, bei denen sich die notwendigen Variablen (Faktoren/Potenz- und Offsetwerte) individuell einstellen lassen. Dazu könnten die in den Formeln verwendeten Faktoren/Potenz- und Offsetwerte individuell im Fertigungsprozess ermittelt und dem Stückprüfprotokoll hinzugefügt werden, so dass diese dann im Rahmen der Inbetriebnahme in das Messgerät eingegeben werden können.

Alternativ können verschiedene Korrekturkurven vordefiniert werden, die während der Inbetriebnahme auswählbar sind (vergleichbar zu AMZ Überstrom-Zeitkurven). Der Mehraufwand für die Eingabe von wenigen Parametern ins Messgerät im Rahmen einer Inbetriebnahme ist gering im Vergleich zu den Kosten für höherwertige Wandler/Sensoren, getrennte Systeme für Schutz und Messung, deren Einbau und Betrieb; dazu kommt eine Variantenreduzierung verschiedenster Stromsensoren bei Schaltanlagenbauern und Sensorherstellern.

Die Ermittlung möglicher Funktionen kann beispielsweise mittels eines Tabellenkalkulationsprogramms (z. B. Excel) erfolgen. Hier wird vorzugsweise der jeweilige Wert der Korrekturfunktion vom ursprünglichen Messwert abgezogen (zur Phasenkorrektur) bzw. mit dem ursprünglichen Messwert multipliziert (zur Amplitudenkorrektur), um ein verbessertes Ergebnis zu erhalten.

1. Möglichkeiten zur Korrektur des Phasenfehlers:

Die Figur 2 zeigt einen typischen Verlauf des Phasenwinkelfehlers Fφ über den Betriebsstrombereich bei Stromwandlern, wie sie in Mittel- und Hochspannungsanlagen eingesetzt werden. Die Figur 2 zeigt den Verlauf für niedrige Ströme I näher im Detail.

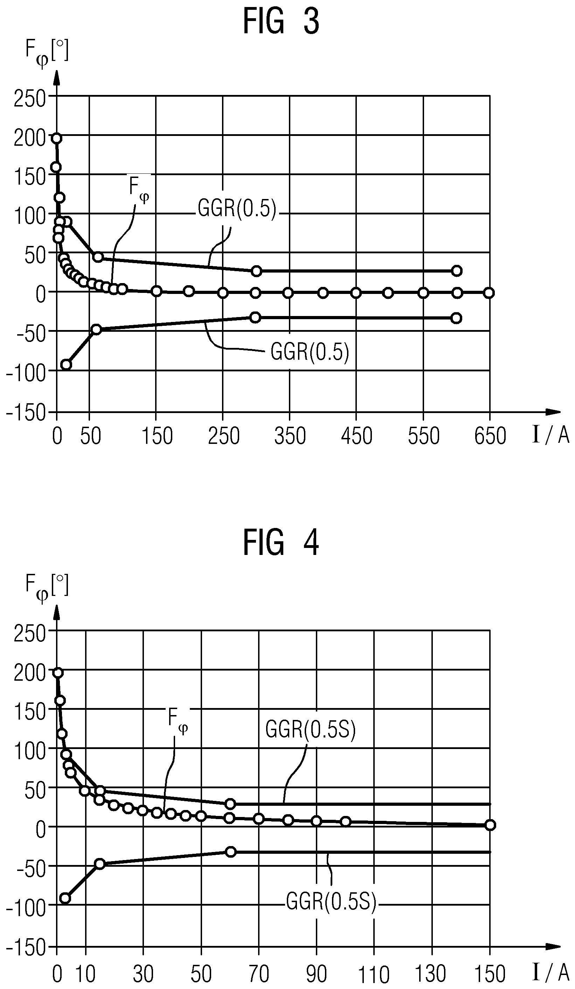

Klar erkennbar ist eine deutliche Zunahme des Phasenfehlers Fφ bei kleineren Strömen. Die Phasenabweichung ist im mittleren/oberen Messbereich relativ konstant. Die Abweichung zum Nullwert kann als konstanter Phasenkorrekturwert im Schutz- /Messgerät verwendet werden. Damit kann der Sensor mit einem Korrekturwert von -33' bereits eine Genauigkeit der Klasse 0.5 erreichen, siehe Genauigkeitsgrenzen GGR(0.5) für die Klasse 0.5 in Figur 3.

Bereits für die nächste Genauigkeitsklasse 0.5S reicht der Einsatz eines konstanten Korrekturwertes nicht mehr aus (siehe Genauigkeitsgrenzen GGR(0.5S) für die Klasse 0.5S in Figur 4), da der Fehler bei kleiner werdenden Betriebsströmen nicht linear zunimmt, sondern überproportional. Damit hat der Korrekturwert hier nahezu keine Auswirkungen mehr.

Es sollte somit vorzugsweise eine dynamische Korrektur der Abweichung in Abhängigkeit des Betriebsstromes erfolgen, damit auch verschieden große Abweichungen korrigiert werden können. Abhängig vom Aufwand und auch von der Leistungsfähigkeit des Messsystems kann eine mathematische (auch nichtlineare) Gleichung gefunden werden, die den ursprünglichen Messwert korrigiert. Diese Gleichung kann auch ggf. nur für einen Teilmessbereich (im obigen Beispiel von 0-150A) eingesetzt werden, da im höheren Strombereich der Fehler durch einen konstanten Korrekturwert nahezu gegen Null geht.

Bei einer geringeren CPU-Leistungsfähigkeit des Messsystems kann ggf. eine lineare Gleichung angewendet werden, die ebenfalls eine Verbesserung erzielt.

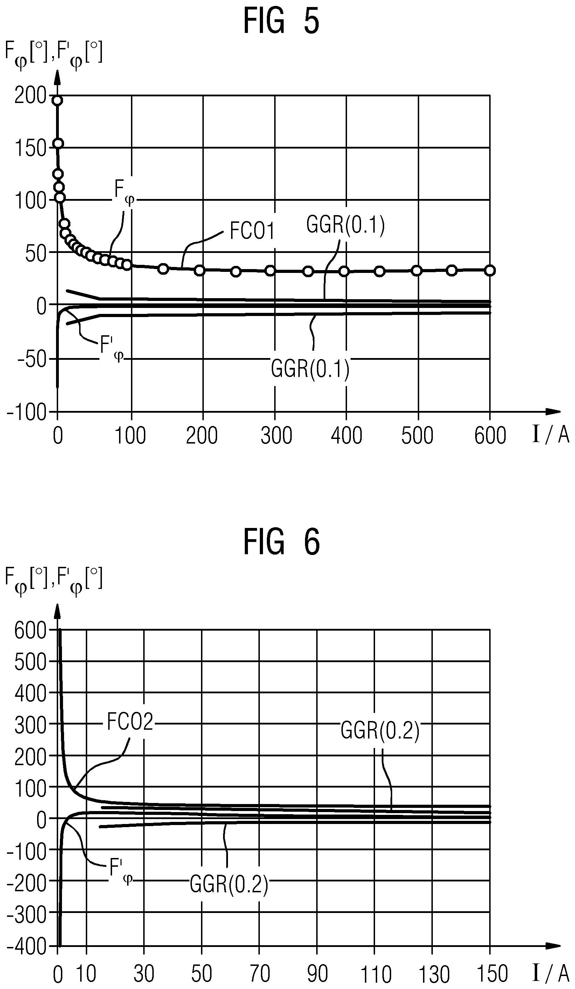

Die Korrekturfunktion kann und sollte im Idealfall die mathematische Beschreibung der Fehlerkurve darstellen bzw. mit dieser identisch sein, wie beispielhaft die Figur 5 zeigt; in Figur 5 ist die Korrekturfunktion "FCO1" mit der Fehlerkurve $F\varphi$ nahezu identisch. Im Messgerät wird dann von der gemessenen Phasenlage je nach Betriebsstrom der stromabhängige Offset (also der jeweils korrespondierende Wert der Korrekturfunktion "FCO1") subtrahiert, als Resultat bleibt die bereinigte, korrigierte Phasenlage $F\varphi'$ mit einem gegen 0' gehenden Phasenfehler (siehe Figur 5). In der Figur 5 sind zusätzlich zu der Funktion FCO1, dem Phasenfehler $F\varphi$ und dem betriebsstromabhängig bereinigten bzw. korrigierte Phasenfehler $F\varphi'$ die Genauigkeitsgrenzen GGR(0.1) für die Klasse 0.1 ext 200 eingezeichnet.

Die korrespondierende Korrekturfunktion FCO1 für die Korrektur gemäß Figur 5 basiert auf einem (subtraktiven) dynamischen Korrekturwert cdyn(i), der zur Korrektur von dem jeweils gemessenen Phasenwert abgezogen wird und vorzugsweise berechnet wird gemäß:

$$cdyn(i) = \frac{200}{\sqrt{i}} + 0{,}015 \cdot i - 15' - \varphi0cor$$

wobei cdyn(i) den dynamischen, vom gemessenen Phasenwert abzuziehenden Korrekturwert, i den Betriebsstrom, -15' einen konstanten Anteil der Korrektur und $\varphi0cor$ den Standardkorrekturwert nach IEC61869-10 bezeichnet. Der konstante Anteil von -15'-$\varphi0cor$ kann auch zu einem einzigen Parameter zusammengefasst werden.

Mit dieser Korrektur lassen sich resultierende Genauigkeiten erzielen, die die höchste Genauigkeitsklasse 0.1 ext 200 erreichen.

Alternativ oder zusätzlich kann der Kehrwert der Stromhöhe zur Bestimmung der Korrekturfunktion herangezogen werden, wie die Figur 6 mit der Korrekturfunktion FCO2 zeigt. Der resultierende bereinigte bzw. korrigierte Phasenfehler $F\varphi'$ und die Genauigkeitsgrenzen GGR(0.2) für die Klasse 0.2 ext 200 sind in der Figur 6 ebenfalls eingezeichnet.

Die korrespondierende Korrekturfunktion FCO2 für die Korrektur gemäß Figur 6 basiert auf einem (subtraktiven) dynamischen Korrekturwert cdyn(i), der zur Korrektur von dem jeweils gemessenen Phasenwert abgezogen wird und vorzugsweise berechnet wird gemäß:

```
cdyn(i) = (300/i) - φ0cor
```

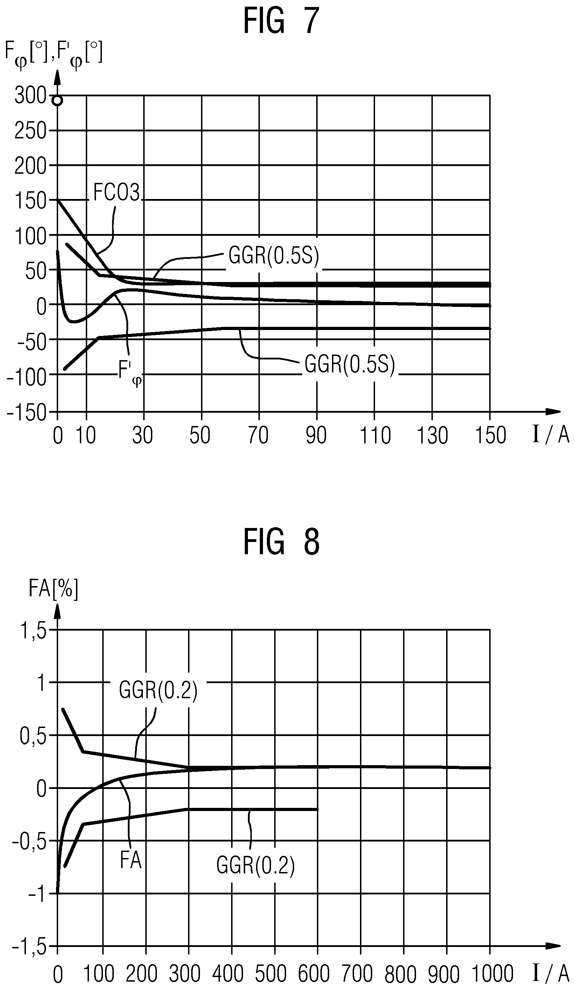

Auch eine vereinfachte lineare Korrektur kann zu einer Verbesserung im unteren Messbereich führen, wie beispielhaft die Figur 7 zeigt. Hier sollte der Einfluss allerdings nur bis zu einer definierten Stromschwelle erfolgen (sichtbar am Knickbereich der Linien in Figur 7); für höhere Stromwerte wird dann vorzugsweise nur noch der Standardkorrekturwert herangezogen. Die Figur 7 zeigt beispielhaft eine entsprechende Korrekturfunktion FCO3. Der resultierende bereinigte bzw. korrigierte Phasenfehler $F\varphi'$ und die Genauigkeitsgrenzen GGR(0.5S) für die Klasse 0.5S sind in der Figur 7 ebenfalls eingezeichnet.

Die korrespondierende Korrekturfunktion FCO3 für die Korrektur gemäß Figur 7 basiert auf einem (subtraktiven) dynamischen Korrekturwert cdyn(i), der zur Korrektur von dem jeweils gemessenen Phasenwert abgezogen wird und vorzugsweise berechnet wird gemäß:

$$cdyn(i) = 5{,}5 \cdot i - 120' - \varphi0cor$$

Die Korrekturfunktion FCO3 wird vorzugsweise für Betriebsströme <25A verwendet, für größere Ströme gilt vorzugsweise:

$$cdyn(i) = -\varphi0cor$$

<u>2. Möglichkeiten zur Korrektur des Amplitudenfehlers:</u>

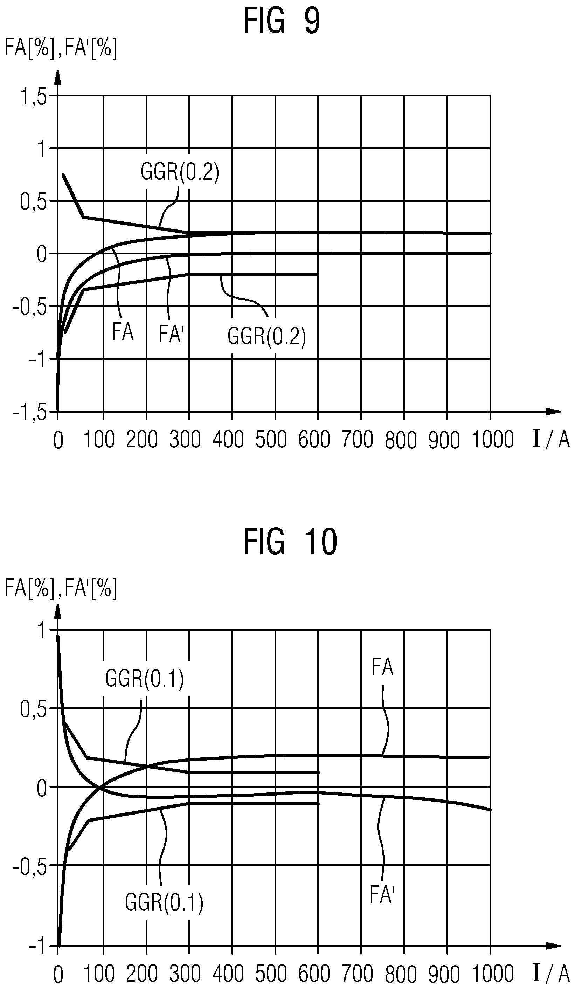

In Figur 8 ist eine deutliche Zunahme des Amplitudenfehlers FA bei kleineren Strömen I erkennbar; die Sättigung von Wandlern/Sensoren wird hier nicht betrachtet. Die Amplitudenabweichung ist im mittleren/oberen Messbereich relativ konstant. Erst mit Beginn des Sättigungsbereiches des Sensors steigt der Fehler wieder rapide an. Die Abweichung zum Nullwert kann als konstanter Amplitudenkorrekturwert im Schutz-/Messgerät verwendet werden. Damit kann der Sensor mit einem Korrekturwert von 0.998 bereits eine Genauigkeit der Klasse 0.2 ext 200 erreichen. Dies zeigt die Figur 9, in der der unkorrigierte Amplitudenfehler FA und der korrigierte Amplitudenfehler FA' eingezeichnet sind.

Es kann auch hier eine dynamische Korrektur der Abweichung in Abhängigkeit des Betriebsstromes erfolgen, damit verschieden große Abweichungen korrigiert werden können. Abhängig vom Aufwand und auch von der Leistungsfähigkeit des Messsystems kann eine mathematische (auch nichtlineare) Gleichung gefunden werden, die den ursprünglichen Messwert korrigiert. Diese Gleichung kann auch ggf. nur für einen Teilmessbereich (in diesem Beispiel bis 200 A) eingesetzt werden, da im mittleren/höheren Strombereich der Fehler durch einen konstanten Korrekturwert nahezu gegen Null geht. Bei einer geringeren CPU-Leistungsfähigkeit des Messsystems kann ggf. eine lineare Gleichung angewendet werden, die ebenfalls eine Verbesserung erzielt.

Die Korrekturfunktion sollte im Idealfall auch bei der Amplitudenkorrektur die mathematische Beschreibung der Fehlerkurve darstellen bzw. mit dieser identisch sein. Für die Amplitudenkorrektur wird der jeweilige Messwert vorzugsweise mit einem Korrekturfaktor cdyn multipliziert, im Gegensatz zur Phasenkorrektur, bei der - wie oben beschrieben - ein variabler Offset als Korrekturwert cdyn vorzugsweise addiert/subtrahiert wird.

Mit einer stromabhängigen Korrektur lässt sich ein korrigierte Amplitudenfehler FA' erreichen, wie er in der Figur 10 beispielhaft gezeigt ist. Die Figur 10 basiert auf einer Korrektur durch Multiplikation mit einem Korrekturfaktor cdyn, der berechnet wurde gemäß:

$$cdyn(i) = 3 \cdot 10^{-9} \cdot i^{2,1} - 9 \cdot 10^{6,1} \cdot i + 1,005$$

Ein Amplitudenkorrekturfaktor CFI ist hier nicht separat notwendig und vorzugsweise im konstanten Wert 1.0005 anteilig mit enthalten. Damit lassen sich resultierende Genauigkeiten erzielen, die die höchste Genauigkeitsklasse 0.1 ext 200 erreichen.

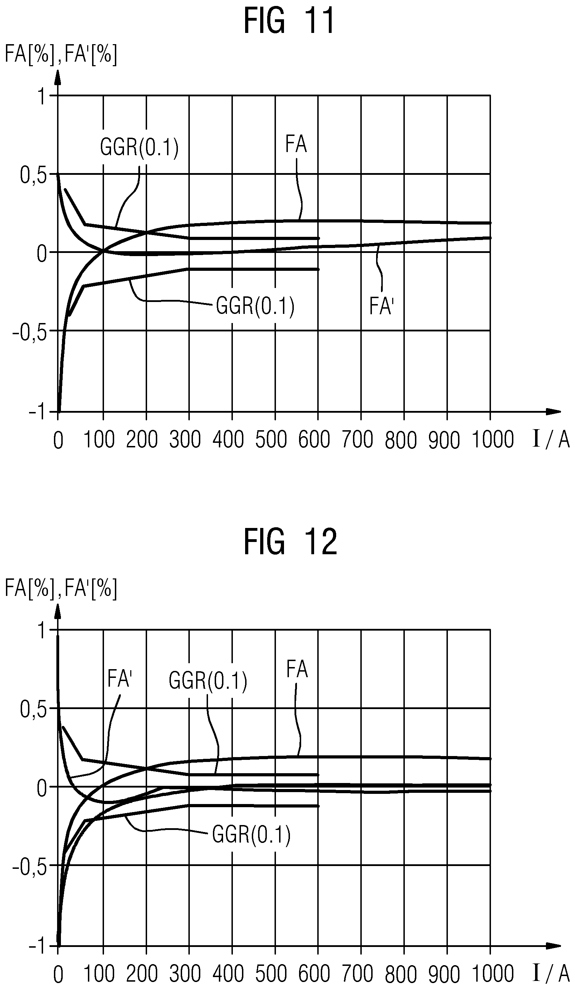

Die Figur 11 zeigt im Rahmen eines zweiten Beispiels eine Korrektur des Amplitudenfehlers durch eine logarithmische Anpassung. Mit einer solchen Amplitudenkorrektur lässt sich ein korrigierte Amplitudenfehler FA' erreichen, wie er in der Figur 11 beispielhaft gezeigt ist. Die Figur 11 basiert auf einer Korrektur durch Multiplikation mit einem Korrekturfaktor cdyn, der berechnet wurde gemäß:

$$cdyn(i) = -1,1 \cdot 10^{-3} \cdot \ln(i) + 1,0045$$

Der Amplitudenkorrekturfaktor CFI ist hier nicht separat notwendig und vorzugsweise im konstanten Wert 1.0045 anteilig mit enthalten.

Die Figur 12 zeigt im Rahmen eines dritten Beispiels eine Korrektur des Amplitudenfehlers durch eine lineare Anpassung im niedrigeren Messbereich. Mit einer solchen Amplitudenkorrektur lässt sich ein korrigierte Amplitudenfehler FA' erreichen, wie er in der Figur 12 beispielhaft gezeigt ist. Die Figur 12 basiert auf einer Korrektur durch Multiplikation mit einem Korrekturfaktor cdyn, der berechnet wurde gemäß:

$$cdyn(i) = -0.000015 \cdot i + 1,00245$$

Die lineare Korrektur bietet sich hier nur für einen Betriebsstrom von 0-250 A an. Für größere Ströme wird dann nur der Standardkorrekturfaktor CFI angewendet; dies ist in Figur 12 bereits berücksichtigt. Für die Umschaltung der Korrektur zwischen linear und fest ab 250 A sollte zur Vermeidung ständiger Umschaltung eine Hysterese von +/- 10 A berücksichtigt werden.

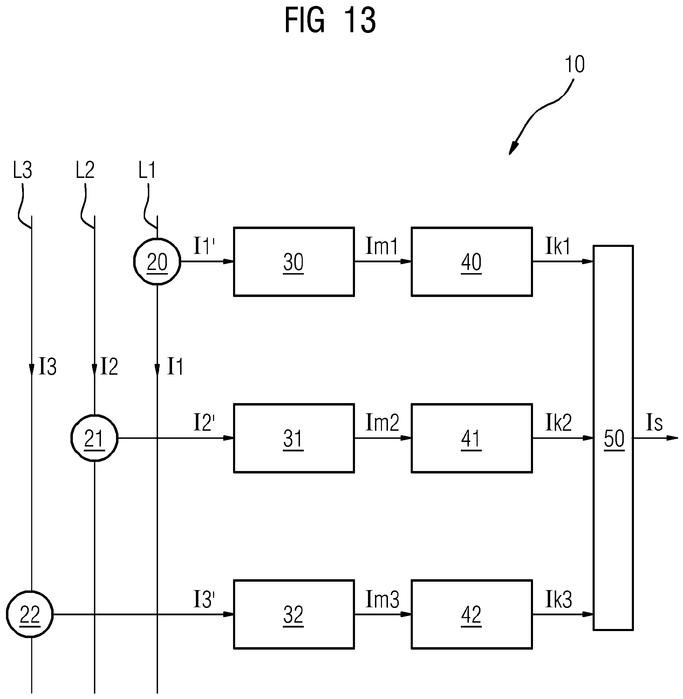

Die Figur 13 zeigt ein Ausführungsbeispiel für eine technische Anlage 10, bei der an einen Phasenleiter L1 einer dreiphasigen elektrischen Energieversorgungsleitung eine Messeinheit 20, beispielsweise in Form eines Stromwandlers, angeschlossen ist. Die Messeinheit erfasst den Strom I1 in dem Phasenleiter L1 und erzeugt ausgangsseitig als Ausgangssignal ein analoges Stromsignal I1', das betragsmäßig kleiner als der Strom I1 im Phasenleiter ist. Das analoge Stromsignal I1' gelangt zu einer Messeinrichtung 30, die ausgangsseitig einen Strommesswert Im1 ausgibt, der beispielsweise den Betrag oder die Amplitude des analogen Stromsignals I1' und damit zumindest mittelbar den Betrag oder die Amplitude des Stromes I1 im Phasenleiter L1 quantifiziert. Eine nachgeordnete Korrektureinheit 40 bildet mit dem Strommesswert einen korrigierten Strommesswert Ik1 gemäß

$$Ik1 = f(\text{Im}1) = \frac{\text{Im}1}{X1 + \dfrac{1}{C3}}$$

wobei Ik1 den korrigierten Strommesswert und Im1 den von der Messeinrichtung 30 erzeugten Strommesswert bezeichnet. X1 ist eine von dem Strommesswert Im1 abhängige Funktion, die in der Korrektureinheit 40 hinterlegt ist und anhand vorheriger Kalibrierungsmessungen für die Messeinheit 20 erzeugt und abgespeichert worden ist.

Als besonders vorteilhaft wird es angesehen, wenn gilt:

$$X1 = \frac{a3}{\text{Im}1 \cdot In}$$

und somit

$$Ik1 = \frac{\text{Im}}{\dfrac{a3}{\text{Im}1 \cdot In} + \dfrac{1}{C3}}$$

wobei a3 eine individuelle, hier also für die Messeinheit 20 individuell ermittelte Konstante, In der Nennstrom der Messeinheit 20 und C3 eine individuelle, hier also für die Messeinheit 20 ermittelte Konstante, beispielsweise gemäß der Norm IEC61869-11, ist.

Bei der beschriebenen Variante erfolgt also eine Korrektur, die von einer einzigen Einflussgröße, nämlich dem jeweiligen Strommesswert Im1 abhängig ist.

Zusätzlich kann auch die Temperatur T der Anlage 10 berücksichtigt werden, vorzugsweise gemäß:

$$Ik1 = \frac{Im1}{\dfrac{a3}{Im1 \cdot In} + \dfrac{1}{C}} \cdot K20(T)$$

wobei K20(T) ein von der Temperatur T abhängiger Korrekturfaktor ist, der den temperaturbedingten Fehler der Messeinheit 20 beschreibt.

Bei der letztgenannten Variante erfolgt also eine Korrektur, die von zwei Einflussgrößen, nämlich dem jeweiligen Strommesswert Im und der jeweiligen Temperatur T, abhängig ist. Die jeweilige Temperatur T wird vorzugsweise über einen separaten Sensor gemessen, der an die Korrektureinheit 40 angeschlossen ist, aber aus Gründen der Übersicht nicht weiter gezeigt ist.

In entsprechender Weise können für die beiden anderen Phasenleiter L2 und L3 weitere Messeinheiten 21 und 22, weitere Messeinrichtungen 31 und 32 und weitere Korrektureinheiten 41 und 42 weitere Ausgangssignale I2', I3', weitere Messwerte Im2 und Im3 und weitere korrigierte Messwerte Ik2 und Ik3 bilden. Ein Summenbildner 50 kann die korrigierten Messwerte Ik1, Ik2 und Ik3 summieren und einen Summenwert Is bilden, der einen Summenstrom in der dreiphasigen Energieversorgungsleitung quantifiziert. Ein separater Summenstromwandler zur Messung des Summenstroms kann somit eingespart werden.

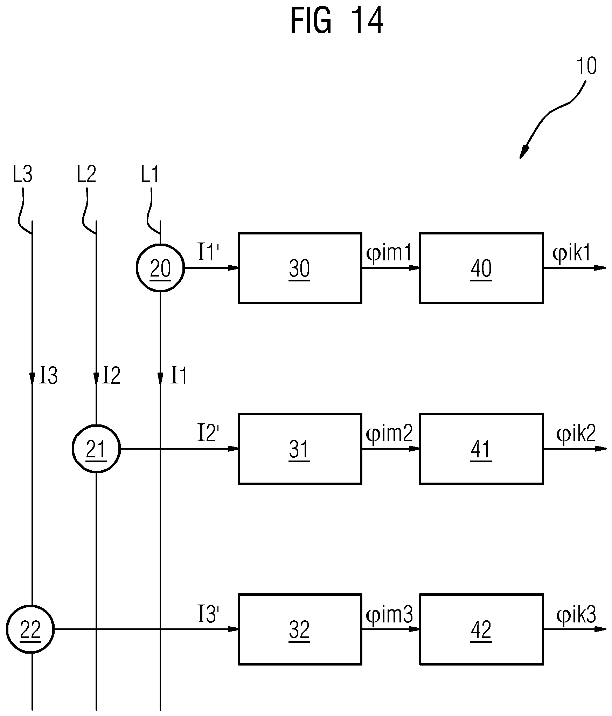

Die Figur 14 zeigt ein Ausführungsbeispiel für eine technische Anlage 10, bei der die Messeinrichtungen 30, 31 und 32 strombezogene Phasenmesswerte φim1, φim2 und φim3 erzeugen und die Korrektureinheiten 40, 41 und 42 korrigierte Phasenmesswerte φik1, φik2 und φik3 bilden. Die Korrektureinheit 40 bildet den korrigierten Phasenmesswert φik1 vorzugsweise gemäß

$$\varphi ik1 = f(I1, \; \varphi m1)$$

wobei f(I1) eine von der Höhe des analogen Stromsignals I1, insbesondere dem Amplituden- oder Effektivwert des analogen Stromsignals, abhängige Funktion ist.

Als vorteilhaft wird es angesehen, wenn gilt:

$$\varphi ik1 = \varphi im1 + \frac{a4}{Im1 \cdot In} + \varphi 4$$

wobei a4 eine individuelle, hier auf die Messeinheit 20 bezogene Konstante, In der Nennstrom der Messeinheit 20 und φ4 ein konstanter, individueller, hier auf die Messeinheit 20 bezogener Phasenkorrekturwert, beispielsweise gemäß der Norm IEC61869-11, ist.

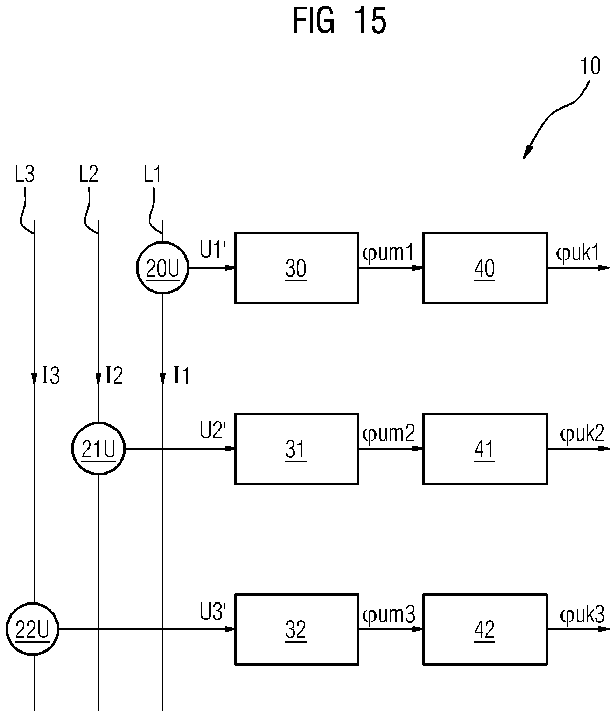

Die Figur 15 zeigt ein Ausführungsbeispiel für eine technische Anlage 10, bei der Messeinheiten 20U, 21U und 22U analoge Spannungssignale U1', U2' und U3' bilden, die die Leiterspannungen an den Phasenleitern L1, L2 und L3 beschreiben bzw. zu diesen zumindest näherungsweise proportional sind.

Die Messeinrichtungen 30, 31 und 32 erzeugen auf die Leiterspannungen der Phasenleiter L1, L2 und L3 spannungsbezogene Phasenmesswerte φum1, φum2 und φum3 und die Korrektureinheiten 40, 41 und 42 bilden korrigierte spannungsbezogene Phasenmesswerte φuk1, φuk2 und φuk3.

Die Korrektureinheit 40 bildet den korrigierten Phasenmesswert φuk1 vorzugsweise gemäß

$$\varphi uk1 = f(U1, \; \varphi m1)$$

wobei φu1k den korrigierten spannungsbezogenen Phasenmesswert und φum1 den von der Messeinrichtung 30 erzeugten Phasenmesswert bezeichnet und f(U1) eine zumindest auch von der Höhe des analogen Spannungssignals U1', insbesondere dem Amplituden- oder Effektivwert des analogen Spannungssignals U1', abhängige Funktion ist.

Als vorteilhaft wird es angesehen, wenn gilt:

$$\varphi uk1 = \varphi um1 + \frac{a2 \cdot K2(T)}{U} + \varphi 1$$

wobei a2 eine für die Messeinheit 20U individuell ermittelte Konstante, K2(T) ein von der Temperatur abhängiger, für die Messeinheit 20U individueller Korrekturfaktor, U ein Amplituden- oder Effektivwert des analogen Spannungssignals U1', und φ1 ein konstanter, für die Messeinheit 20U individuell ermittelter Phasenkorrekturwert, beispielsweise gemäß der Norm IEC61869-11, ist.

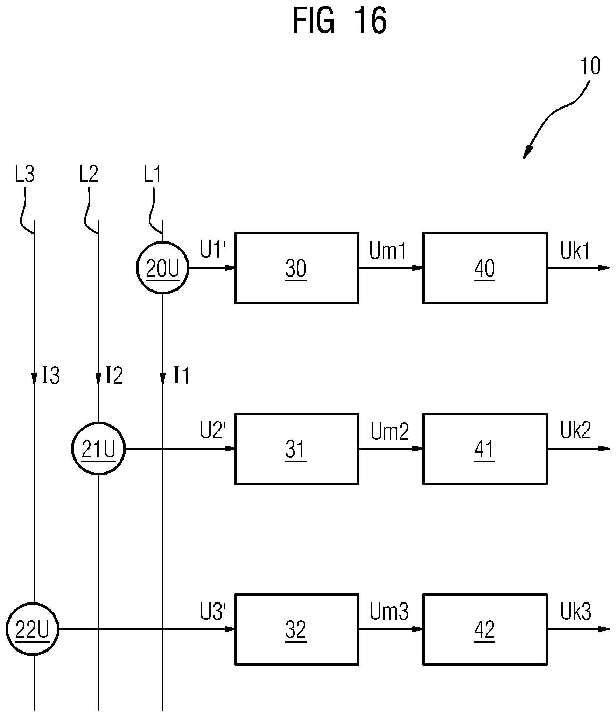

Die Figur 16 zeigt ein Ausführungsbeispiel für eine technische Anlage 10, bei der Messeinheiten 20U, 21U und 22U analoge Spannungssignale U1', U2' und U3' bilden, die die Leiterspannungen an den Phasenleitern L1, L2 und L3 beschreiben bzw. zu diesen zumindest näherungsweise proportional sind.

Die Messeinrichtungen 30, 31 und 32 erzeugen auf die Leiterspannungen der Phasenleiter L1, L2 und L3 spannungsbezogene Amplitudenmesswerte Um1, Um2 und Um3 und die Korrektureinheiten 40, 41 und 42 bilden korrigierte spannungsbezogene Amplitudenmesswerte Uk1, Uk2 und Uk3.

Die Korrektureinheit 40 bildet den korrigierten Amplitudenmesswert Uk1 vorzugsweise gemäß

$$Uk1 = f(Um1)$$

wobei Uk1 den korrigierten Spannungsmesswert und Um1 den von der Messeinrichtung 30 erzeugten Spannungsmesswert bezeichnet und f(Um) eine zumindest auch von dem von der Messeinrichtung 30 erzeugten Spannungsmesswert Um1 abhängige Funktion ist.

Als vorteilhaft wird es angesehen, wenn gilt:

$$Uk1 = \frac{Um1}{X1 + \dfrac{1}{C1}}$$

wobei X1 eine von einer Betriebsgröße der Anlage 10, beispielsweise dem von der Messeinrichtung 30 erzeugten Spannungsmesswert Um1, abhängige, für die Messeinheit 20 individuell ermittelte Funktion und C1 ein konstanter, für die Messeinheit 20 individuell ermittelter Korrekturwert, beispielsweise gemäß der Norm IEC61869-11, ist.

Als besonders vorteilhaft wird es angesehen, wenn gilt:

$$X1 = \frac{a1}{Um1}$$

und somit

$$Uk1 = \frac{Um1}{\dfrac{a1}{Um1} + \dfrac{1}{C1}}$$

wobei a1 eine für die Messeinheit U20 individuell ermittelte Konstante ist.

Bei der beschriebenen Variante erfolgt also eine Korrektur, die von einer einzigen Einflussgröße, nämlich dem jeweiligen Spannungsmesswert Um, abhängig ist.

Zusätzlich kann auch die Temperatur T der Anlage 10 berücksichtigt werden, vorzugsweise gemäß:

$$Uk1 = \frac{Um1}{X1 + \dfrac{1}{C1}} \cdot K1(T)$$

wobei K1(T) ein von der Temperatur abhängiger und für die Messeinheit U20 individuell ermittelter Korrekturfaktor ist.

Bei der letztgenannten Variante erfolgt also eine Korrektur, die von zwei Einflussgrößen, nämlich dem jeweiligen Spannungsmesswert Um1 und der jeweiligen Temperatur T, abhängig ist. Die jeweilige Temperatur T wird vorzugsweise über einen separaten Sensor gemessen, der an die Korrektureinheit 40 angeschlossen ist, aber aus Gründen der Übersicht nicht weiter gezeigt ist.

Die in den Figuren 13 bis 16 gezeigten Messeinrichtungen 30, 31 und 32 und die Korrektureinheiten sind vorzugsweise in einem Schutz- oder Messgerät integriert, das zum Schutz und/ oder Überwachen der Energieversorgungsleitung bzw. der drei Phasenleiter L1, L2 und L3 der technischen Anlage 10 dient.

Die oben im Zusammenhang mit den Figuren 1 bis 16 beschriebenen Ausführungsvarianten können eine, mehrere oder alle der nachfolgend stichpunkartig nochmals zusammengefassten Eigenschaften aufweisen:

- Kosteneinsparung durch die Verwendung von Wandlern/Senso ren einer geringeren Genauigkeitsklasse als sonst nötig wäre.
- Kostenreduktion (Kauf, Montage, Wartung) durch Einsparung eines Summenstromwandlers zur Messung; der Summenstrom kann nur aus Phasenstromwerten berechnet werden.
- Kosteneinsparung durch Nutzen von Messeinheiten für mehrere Funktionen (Schutz und Messung) in nur einem Gerät, möglich wegen der Verbesserung der Qualität der Messwerte aufgrund der Korrektur.
- Reduzierte Wandler-/Sensorvielfalt, dadurch geringere Lagervorhaltung, einfachere Nachrüstung von Messfunktionen in Bestandsanlagen.
- Mathematische Darstellung und Erfassung typischer Fehlerkurven für Amplitude und Phasenlage von Strom- und Spannungsmesswerten. Auf der Basis der Fehlerkurven erfolgt die Berechnung einer Kompensationskurve/-linie, mit der die gemessenen Werte in Echtzeit nachbearbeitet werden.
- Anstatt einer "Korrekturformel" könnten auch für einzelne definierte Werte, wie z. B. Stromwerte, als Korrekturparameter eingegeben werden, beispielsweise von Hand oder durch Einscannen. Im Messgerät selbst können dann die Korrekturparameter zwischen den definierten eingegebenen Korrekturparametern zur Bildung von Zwischenwerten interpoliert werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

| 10 | technische Anlage |
|----|----|
| 20 | Messeinheit |
| 20U | Messeinheit |
| 21 | Messeinheit |
| 21U | Messeinheit |
| 22 | Messeinheit |
| 22U | Messeinheit |
| 30 | Messeinrichtung |
| 31 | Messeinrichtung |
| 32 | Messeinrichtung |

| | |
|---|---|
| 40 | Korrektureinheit |
| 41 | Korrektureinheit |
| 42 | Korrektureinheit |
| 50 | Summenbildner |
| | |
| FA | Amplitudenfehler |
| FA' | korrigierter Amplitudenfehler |
| I1 | Strom |
| I2 | Strom |
| I3 | Strom |
| I1' | Stromsignal / Ausgangssignal |
| I2' | Stromsignal / Ausgangssignal |
| I3' | Stromsignal / Ausgangssignal |
| Ik1 | korrigierter Strommesswert |
| Ik2 | korrigierter Strommesswert |
| Ik3 | korrigierter Strommesswert |
| Im1 | Strommesswert |
| Im2 | Strommesswert |
| Im3 | Strommesswert |
| Is | Summenwert |
| L1 | Phasenleiter |
| L2 | Phasenleiter |
| L3 | Phasenleiter |
| T | Temperatur |
| U1' | Spannungssignal / Ausgangssignal |
| U2' | Spannungssignal / Ausgangssignal |
| U3' | Spannungssignal / Ausgangssignal |
| Uk1 | korrigierter spannungsbezogener Amplitudenmesswert |
| Uk2 | korrigierter spannungsbezogener Amplitudenmesswert |
| Uk3 | korrigierter spannungsbezogener Amplitudenmesswert |
| Um1 | spannungsbezogener Amplitudenmesswert |
| Um2 | spannungsbezogener Amplitudenmesswert |
| Um3 | spannungsbezogener Amplitudenmesswert |
| $\varphi ik1$ | korrigierter strombezogener Phasenmesswert |
| $\varphi ik2$ | korrigierter strombezogener Phasenmesswert |
| $\varphi ik1$ | korrigierter strombezogener Phasenmesswert |
| $\varphi im1$ | strombezogener Phasenmesswert |
| $\varphi im2$ | strombezogener Phasenmesswert |
| $\varphi im3$ | strombezogener Phasenmesswert |
| $\varphi uk1$ | korrigierter spannungsbezogener Phasenmesswert |
| $\varphi uk2$ | korrigierter spannungsbezogener Phasenmesswert |
| $\varphi uk3$ | korrigierter spannungsbezogener Phasenmesswert |
| $\varphi um1$ | spannungsbezogener Phasenmesswert |
| $\varphi um2$ | spannungsbezogener Phasenmesswert |
| $\varphi um3$ | spannungsbezogener Phasenmesswert |

**Patentansprüche**

1. Anordnung mit einer Messeinrichtung (30, 31, 32), die geeignet ist, ein von einer Messeinheit (20, 21, 22, 20U, 21U, 22U) geliefertes Ausgangssignal (I1', I2', I3', U1', U2', U3'), das eine Betriebsgröße einer technischen Anlage (10) beschreibt, zu messen und einen Messwert (Im1, Im2, Im3, $\varphi$im1, $\varphi$im2, $\varphi$im3, Um1, Um2, Um3, $\varphi$um1, $\varphi$um2, $\varphi$um3,) zu erzeugen,

   - wobei die Anordnung ein Schutz- oder Messgerät zum Anschluss an eine analoge Messeinheit (20, 21, 22, 20U, 21U, 22U) einer Hoch-, Mittel- oder Niederspannungsanlage bildet oder ein solches Schutz- oder Messgerät zumindest auch umfasst,
   - wobei die Anordnung eine Korrektureinheit (40, 41, 42) aufweist, die dazu ausgestaltet ist, den von der Messeinrichtung (30, 31, 32) erzeugten Messwert gemäß einer messeinheitsindividuell zugeordneten Korrekturanweisung zu korrigieren und einen korrigierten Messwert (Ik1, Ik2, Ik3, $\varphi$ik1, $\varphi$ik2, $\varphi$ik3, Uk1, Uk2, Uk3, $\varphi$uk1, $\varphi$uk2, $\varphi$uk3,) zu erzeugen,

   wobei der korrigierte Messwert einen elektrischen Zustand der Hoch-, Mittel- oder Niederspannungsanlage beschreibt,

   - wobei die messeinheitsindividuelle Korrekturanweisung von dem von der Messeinrichtung (30, 31, 32) erzeugten Messwert abhängt,
   - und wobei die messeinheitsindividuelle Korrekturanweisung ermittelt worden ist anhand einer für die Messeinheit (20, 21, 22, 20U, 21U, 22U) gemessenen Fehlerkurve oder Fehlerkurvenschar, die einen von der Messeinheit (20, 21, 22, 20U, 21U, 22U) in dem Ausgangssignal (I1', I2', I3', U1', U2', U3') hervorgerufenen Fehler betriebsgrößenabhängig quantifiziert, und
   - durch die Korrektur des von der Messeinrichtung (30, 31, 32) erzeugten Messwerts mittels der Korrekturanweisung der von der Messeinheit (20, 21, 22, 20U, 21U, 22U) hervorgerufene Fehler kompensiert oder zumindest reduziert wird,
   **dadurch gekennzeichnet, dass**
   - die Korrekturanweisung eine zu der gemessenen Fehlerkurve oder Fehlerkurvenschar inverse oder komplementäre Funktion oder Funktionenschar enthält oder durch eine solche inverse oder komplementäre Funktion oder Funktionenschar gebildet wird, wobei die Korrekturanweisung auch von der Höhe einer anderen Betriebsgröße der technischen Anlage (10) abhängt.

2. Anordnung nach einem der voranstehenden Ansprüche, **dadurch gekennzeichnet, dass** die Messeinheit (20, 21, 22) ein Stromwandler ist, der eine Spule, insbesondere eine eisenfreie oder eisenbehaftete Spule, umfasst und als analoges Ausgangssignal (I1', I2', I3') ein analoges Stromsignal erzeugt.

3.  Anordnung nach einem der voranstehenden Ansprüche, **dadurch gekennzeichnet, dass** die Messeinheit (20U, 21U, 22U) ein Spannungswandler ist, der einen Transformator, einen kapazitiven Spannungsteiler und/oder einen ohmschen Spannungsteiler umfasst und als analoges Ausgangssignal (U1', U2', U3') ein analoges Spannungssignal erzeugt.

4.  Anordnung nach einem der voranstehenden Ansprüche, **dadurch gekennzeichnet, dass** die Anordnung eine Eingabeeinrichtung aufweist, die eine Eingabe der Korrekturanweisung oder zumindest die Eingabe eines oder mehrerer Korrekturparameter, mit denen sich die Korrekturanweisung bilden lässt, aufweist.

5.  Anordnung nach Anspruch 4, **dadurch gekennzeichnet, dass** die Eingabeeinrichtung eine Scanneinrichtung umfasst, die ein Einlesen der Korrekturanweisung oder zumindest das Einlesen eines oder mehrerer Korrekturparameter, mit denen sich die Korrekturanweisung bilden lässt, aufweist.

6.  Anordnung nach einem der voranstehenden Ansprüche, **dadurch gekennzeichnet, dass** die messeinheitsindividuell zugeordnete Korrekturanweisung die Korrektur des von der Messeinrichtung (30, 31, 32) erzeugten Messwerts unter Berücksichtigung des Betrags, des Effektivwerts und/oder der Phase des jeweiligen von der Messeinrichtung (30, 31, 32) erzeugten Messwerts vorsieht.

7.  Anordnung nach einem der voranstehenden Ansprüche, **dadurch gekennzeichnet, dass**

    das Ausgangssignal (U1', U2', U3') ein analoges Spannungssignal ist, der von der Messeinrichtung (30, 31, 32) erzeugte Messwert ein Spannungsmesswert, insbesondere ein korrigierter Amplituden- oder Effektivwert, ist und der korrigierte Messwert ein korrigierter Spannungsmesswert, insbesondere ein korrigierter Amplituden- oder Effektivwert, ist, den die Korrektureinheit (40, 41, 42) bildet gemäß

    $$\mathrm{Uk} \;=\; \mathrm{f(Um)}$$

    wobei Uk den korrigierten Spannungsmesswert und Um den von der Messeinrichtung (30, 31, 32) erzeugten Spannungsmesswert bezeichnet und f(Um) eine zumindest auch von dem von der Messeinrichtung (30, 31, 32) erzeugten Spannungsmesswert abhängige Funktion ist.

8.  Anordnung nach einem der voranstehenden Ansprüche, **dadurch gekennzeichnet, dass**

    das Ausgangssignal (U1', U2', U3') ein analoges Spannungssignal ist, der von der Messeinrichtung (30, 31, 32) erzeugte Messwert ein Phasenmesswert ist und der korrigierte Messwert ein korrigierter Phasenmesswert ist, den die Korrektureinheit (40, 41, 42) bildet gemäß

    $$\varphi\mathrm{k} \;=\; \mathrm{f(U, \; \varphi m)}$$

    wobei $\varphi$k den korrigierten Phasenmesswert und $\varphi$m den von der Messeinrichtung (30, 31, 32) erzeugte Phasenmesswert bezeichnet und f(U) eine zumindest auch von der Höhe des analogen Spannungssignals, insbesondere dem Amplituden- oder Effektivwert des analogen Spannungssignals, abhängige Funktion ist.

9.  Anordnung nach einem der voranstehenden Ansprüche, **dadurch gekennzeichnet, dass**

    das Ausgangssignal (I1', I2', I3') ein analoges Stromsignal ist, der von der Messeinrichtung (30, 31, 32) erzeugte Messwert ein Strommesswert ist und der korrigierte Messwert ein korrigierter Strommesswert ist, den die Korrektureinheit (40, 41, 42) bildet gemäß

    $$\mathrm{Ik} \;=\; \mathrm{f(Im)}$$

    wobei Ik den korrigierten Strommesswert und Im den von der Messeinrichtung (30, 31, 32) erzeugten Strommesswert bezeichnet und f(Im) eine zumindest auch von dem von der Messeinrichtung (30, 31, 32) erzeugten Strommesswert abhängige Funktion ist.

10. Anordnung nach einem der voranstehenden Ansprüche, **dadurch gekennzeichnet, dass**

    das Ausgangssignal (I1', I2', I3') ein analoges Stromsignal ist, der von der Messeinrichtung (30, 31, 32) erzeugte Messwert ein Phasenmesswert ist und der korrigierte Messwert ein korrigierter Phasenmesswert ist, den die Korrektureinheit (40, 41, 42) bildet gemäß

    $$\varphi\mathrm{k} \;=\; \mathrm{f(I, \; \varphi m)}$$

    wobei $\varphi$k den korrigierten Phasenmesswert und $\varphi$m den von der Messeinrichtung (30, 31, 32) erzeugten Phasenmesswert bezeichnet und f(I) eine zumindest auch von der Höhe des analogen Stromsignals, insbesondere dem Amplituden- oder Effektivwert des analogen Stromsignals, abhängige Funktion ist.

11. Anordnung nach einem der voranstehenden Ansprüche, **dadurch gekennzeichnet, dass** die messeinheitsindividuell zugeordnete Korrekturanweisung die Korrektur des Messwerts der Messeinrichtung (30, 31, 32) unter Berücksichtigung eines Umgebungsparameters, insbesondere der jeweiligen Umgebungstemperatur der Messeinheit (20, 21, 22, 20U, 21U, 22U), vorsieht.

12. Verfahren zum Betreiben einer Anordnung mit einer Messeinrichtung (30, 31, 32), die ein von einer Messeinheit (20,21, 22, 20U, 21U, 22U) geliefertes Ausgangssignal (I1', I2', I3', U1', U2', U3'), das eine Betriebsgröße einer technischen Anlage (10) beschreibt, misst und einen Messwert erzeugt,

    - wobei die Anordnung ein Schutz- oder Messgerät zum Anschluss an eine analoge Messeinheit (20, 21, 22, 20U, 21U, 22U) einer Hoch-, Mittel- oder Niederspannungsanlage bildet oder ein solches Schutz- oder Messgerät zumindest auch umfasst,
    - und wobei der von der Messeinrichtung (30, 31, 32) erzeugte Messwert gemäß einer messeinheitsindividuell zugeordneten Korrekturanweisung korrigiert wird und ein korrigierter Messwert erzeugt wird, wobei das Maß der Korrektur gemäß der messeinheitsindividuellen Korrekturanweisung von dem von der Messeinrichtung (30, 31, 32) erzeugten Messwert abhängt,

wobei der korrigierte Messwert einen elektrischen Zustand der Hoch-, Mittel- oder Niederspannungsanlage beschreibt,

    - und wobei die messeinheitsindividuelle Korrekturanweisung ermittelt worden ist anhand einer für die Messeinheit (20, 21, 22, 20U, 21U, 22U) gemessenen Fehlerkurve oder Fehlerkurvenschar, die einen von der Messeinheit (20, 21, 22, 20U, 21U, 22U) in dem Ausgangssignal (I1', I2', I3', U1', U2', U3') hervorgerufenen Fehler betriebsgrößenabhängig quantifiziert, und
    - durch die Korrektur des von der Messeinrichtung (30, 31, 32) erzeugten Messwerts mittels der Korrekturanweisung der von der Messeinheit (20, 21, 22, 20U, 21U, 22U) hervorgerufene Fehler kompensiert oder zumindest reduziert wird,**dadurch gekennzeichnet, dass**
    - die Korrekturanweisung eine zu der gemessenen Fehlerkurve oder Fehlerkurvenschar inverse oder komplementäre Funktion oder Funktionenschar enthält oder durch eine solche inverse oder komplementäre Funktion oder Funktionenschar gebildet wird, wobei die Korrekturanweisung auch von der Höhe einer anderen Betriebsgröße der technischen Anlage (10) abhängt.

**Claims**

1. Arrangement comprising a measuring device (30, 31, 32) which is suitable for measuring an output signal (I1', I2', I3', U1', U2', U3'), delivered by a measuring unit (20, 21, 22, 20U, 21U, 22U), that describes an operating variable of a technical installation (10) and for producing a measured value (Im1, Im2, Im3, φim1, φim2, φim3, Um1, Um2, Um3, φum1, φum2, φum3),

    - wherein the arrangement forms a protection or measuring device for connection to an analogue measuring unit (20, 21, 22, 20U, 21U, 22U) of a high-voltage, medium-voltage or low-voltage system or at least also includes such a protection or measuring device,
    - wherein the arrangement comprises a correction unit (40, 41, 42) which is configured to correct the measured value produced by the measuring device (30, 31, 32) in accordance with a correction instruction associated with each individual measuring unit and to produce a corrected measured value (Ik1, Ik2, Ik3, φik1, φik2, φik3, Uk1, Uk2, Uk3, φuk1, φuk2, φuk3), wherein the corrected measured value describes an electrical state of the high-voltage, medium-voltage or low-voltage system,
    - wherein the correction instruction specific to the measuring units depends on the measured value produced by the measuring device (30, 31, 32),
    - and wherein the correction instruction specific to the measuring units has been determined on the basis of an error curve or a family of error curves, measured for the measuring unit (20, 21, 22, 20U, 21U, 22U), that quantifies an error produced by the measuring unit (20, 21, 22, 20U, 21U, 22U) in the output signal (I1', I2', I3', U1', U2', U3') according to operating variables, and
    - correction of the measured value produced by the measuring device (30, 31, 32) by means of the correction instruction compensates for or at least reduces the error produced by the measuring unit (20, 21, 22, 20U, 21U, 22U),
    **characterized in that**
    - the correction instruction contains a function or family of functions that is inverse or complementary with respect to the measured error curve or family of error curves, or said correction function is formed by such an inverse or complementary function or family of functions, the correction instruction also depending on the level of another operating variable of the technical installation (10).

2. Arrangement according to one of the preceding claims, **characterized in that** the measuring unit (20, 21, 22) is a current transformer which includes a coil, in particular an ironless or iron-core coil, and produces an analogue current signal as analogue output signal (I1', I2', I3').

3. Arrangement according to either of the preceding claims, **characterized in that** the measuring unit (20U, 21U, 22U) is a voltage transformer which includes a transformer, a capacitive voltage divider and/or a resistive voltage divider and produces an analogue voltage signal as analogue output signal (U1', U2', U3').

4. Arrangement according to one of the preceding claims, **characterized in that** the arrangement comprises an input device which inputs the correction instruction or at least inputs one or more correction parameters that can be used to form the correction instruction.

5. Arrangement according to Claim 4, **characterized in that** the input device includes a scanning device which reads in the correction instruction or at least reads in one or more correction parameters that can be used to form the correction instruction.

6. Arrangement according to one of the preceding claims, **characterized in that** the correction instruction associated with each individual measuring unit provides for correction of the measured value produced by the measuring device (30, 31, 32) in consideration of the absolute value, the root mean square value and/or the phase of the respective measured value produced by the measuring device (30, 31, 32).

7. Arrangement according to one of the preceding claims, **characterized in that** the output signal (U1', U2', U3') is an analogue voltage signal, the measured value produced by the measuring device (30, 31, 32) is a voltage measured value, in particular a corrected amplitude value or root mean square value, and the corrected measured value is a corrected voltage measured value, in particular a corrected amplitude value or root mean square value, that the correction unit (40, 41, 42) forms in accordance with

$$Uk = f(Um)$$

where Uk denotes the corrected voltage measured value and Um denotes the voltage measured value produced by the measuring device (30, 31, 32) and f(Um) is a function that is at least also dependent on the voltage measured value produced by the measuring device (30, 31, 32).

8. Arrangement according to one of the preceding claims, **characterized in that** the output signal (U1', U2', U3') is an analogue voltage signal, the measured value produced by the measuring device (30, 31, 32) is a phase measured value and the corrected measured value is a corrected phase measured value that the correction unit (40, 41, 42) forms in accordance with

$$\varphi k = f(U, \varphi m)$$

where $\varphi k$ denotes the corrected phase measured value and $\varphi m$ denotes the phase measured value produced by the measuring device (30, 31, 32) and f(U) is a function that is at least also dependent on the level of the analogue voltage signal, in particular the amplitude value or root mean square value of the analogue voltage signal.

9. Arrangement according to one of the preceding claims, **characterized in that** the output signal (I1', I2', I3') is an analogue current signal, the measured value produced by the measuring device (30, 31, 32) is a current measured value and the corrected measured value is a corrected current measured value that the correction unit (40, 41, 42) forms in accordance with

$$Ik = f(Im)$$

where Ik denotes the corrected current measured value and Im denotes the current measured value produced by the measuring device (30, 31, 32) and f(Im) is a function that is at least also dependent on the current measured value produced by the measuring device (30, 31, 32).

10. Arrangement according to one of the preceding claims, **characterized in that**

the output signal (I1', I2', I3') is an analogue current signal, the measured value produced by the measuring device (30, 31, 32) is a phase measured value and the corrected measured value is a corrected phase measured value that the correction unit (40, 41, 42) forms in accordance with

$$\varphi k = f (I, \varphi m)$$

where $\varphi k$ denotes the corrected phase measured value and $\varphi m$ denotes the phase measured value produced by the measuring device (30, 31, 32) and f(I) is a function that is at least also dependent on the level of the analogue current signal, in particular the amplitude value or root mean square value of the analogue current signal.

11. Arrangement according to one of the preceding claims, **characterized in that**

the correction instruction associated with each individual measuring unit provides for correction of the measured value of the measuring device (30, 31, 32) in consideration of an environmental parameter, in particular the respective ambient temperature of the measuring unit (20, 21, 22, 20U, 21U, 22U).

12. Method for operating an arrangement comprising a measuring device (30, 31, 32) that measures an output signal (I1', I2', I3', U1', U2', U3'), delivered by a measuring unit (20, 21, 22, 20U, 21U, 22U), that describes an operating variable of a technical installation (10), and produces a measured value,

- wherein the arrangement forms a protection or measuring device for connection to an analogue measuring unit (20, 21, 22, 20U, 21U, 22U) of a high-voltage, medium-voltage or low-voltage system or at least also includes such a protection or measuring device,
- and wherein the measured value produced by the measuring device (30, 31, 32) is corrected in accordance with a correction instruction associated with each individual measuring unit and a corrected measured value is produced, the measure of correction in accordance with the correction instruction specific to the measuring units depending on the measured value produced by the measuring device (30, 31, 32),
wherein the corrected measured value describes an electrical state of the high-voltage, medium-voltage or low-voltage system,
- and wherein the correction instruction specific to the measuring units has been determined on the basis of an error curve or a family of error curves, measured for the measuring unit (20, 21, 22, 20U, 21U, 22U), that quantifies an error produced by the measuring unit (20, 21, 22, 20U, 21U, 22U) in the output signal (I1', I2', I3', U1', U2', U3') according to operating variables, and
- correction of the measured value produced by the measuring device (30, 31, 32) by means of the correction instruction compensates for or at least reduces the error produced by the measuring unit (20, 21, 22, 20U, 21U, 22U),
**characterized in that**
- the correction instruction contains a function or family of functions that is inverse or complementary with respect to the measured error curve or family of error curves, or said correction function is formed by such an inverse or complementary function or family of functions, the correction instruction also depending on the level of another operating variable of the technical installation (10).

**Revendications**

1. Agencement comprenant un dispositif (30, 31, 32) de mesure, qui est propre à mesurer un signal (I1', I2', I3', U1', U2', U3') de sortie qui est donné par une unité (20, 21, 22, 20U, 21U, 22U) de mesure et qui décrit une grandeur de fonctionnement d'une installation (10) technique, et à produire une valeur (Im1, Im2, Im3, $\varphi$im1, $\varphi$im2, $\varphi$im3, Um1, Um2, Um3, $\varphi$um1, $\varphi$um2, $\varphi$um3) de mesure,

- dans lequel l'agencement forme un appareil de protection ou de mesure pour le raccordement à une unité (20, 21, 22, 20U, 21U, 22U) analogique de mesure d'une installation de la haute, moyenne ou basse tension, ou du moins comprend également un tel appareil de protection ou de mesure,
- dans lequel l'agencement a une unité (40, 41, 42) de correction, qui est conformée pour corriger la valeur de mesure produite par le dispositif (30, 31, 32) de mesure suivant une instruction de correction associée individuellement à l'unité de mesure et pour produire une valeur (Ik1, Ik2, Ik3, $\varphi$ik1, $\varphi$ik2, $\varphi$ik3, Uk1, Uk2, Uk3, $\varphi$uk1, $\varphi$uk2, $\varphi$uk3) de mesure corrigée,
dans lequel la valeur de mesure corrigée décrit un état électrique de l'installation de haute, moyenne ou basse tension,
- dans lequel l'instruction de correction individuelle à l'unité de mesure dépend de la valeur de mesure produite par le dispositif (30, 31, 32) de mesure,
- et dans lequel l'instruction de correction individuelle à l'unité de mesure a été déterminée à l'aide d'une courbe d'erreur ou d'une famille de courbes d'erreur, mesurée pour l'unité (20, 21, 22, 20U, 21U, 22U) de mesure, qui quantifie, en fonction de la grandeur de fonctionnement, des erreurs provoquées par l'unité (20, 21, 22, 20U, 21U, 22U) de mesure dans le signal (I1', I2', I3', U1', U2', U3') de sortie, et

- par la correction de la valeur de mesure produite par le dispositif (30, 31, 32) de mesure, on compense ou du moins on réduit, au moyen de l'instruction de correction, l'erreur provoquée par l'unité (20, 21, 22, 20U, 21U, 22U) de mesure,

**caractérisé en ce que**

- l'instruction de correction contient une fonction ou une famille de fonctions inverse ou complémentaire de la courbe d'erreur ou de la famille de courbes d'erreur mesurée ou est formée par une fonction ou une famille de fonctions inverses ou complémentaires de ce genre, dans lequel l'instruction de correction dépend également du niveau d'une autre grandeur de fonctionnement de l'installation (10) technique.

2.  Agencement suivant l'une des revendications précédentes, **caractérisé en ce que**
    l'unité (20, 21, 22) de mesure est un transformateur de courant, qui comprend une bobine, en particulier une bobine sans fer ou chargée de fer, et produit un signal de courant analogique comme signal (I1', I2', I3') analogique de sortie.

3.  Agencement suivant l'une des revendications précédentes, **caractérisé en ce que**
    l'unité (20U, 21U, 22U) de mesure est un convertisseur de tension, qui comprend un transformateur, un diviseur de tension capacitif et/ou un diviseur de tension ohmique et qui produit un signal analogique de tension comme signal (U1', U2', U3') analogique de sortie.

4.  Agencement suivant l'une des revendications précédentes, **caractérisé en ce que**
    l'agencement a un dispositif d'entrée, qui a une entrée de l'instruction de correction ou du moins l'entrée d'un ou de plusieurs paramètres de correction, par lesquels l'instruction de correction peut se former.

5.  Agencement suivant la revendication 4, **caractérisé en ce que**
    le dispositif d'entrée comprend un dispositif de balayage, qui a une lecture de l'instruction de correction ou du moins la lecture d'un ou de plusieurs paramètres de correction, par lesquels l'instruction de correction peut se former.

6.  Agencement suivant l'une des revendications précédentes, **caractérisé en ce que**
l'instruction de correction associée individuellement à l'unité de mesure prévoit la correction de la valeur de mesure produite par le dispositif (30, 31, 32) de mesure en tenant compte de la valeur absolue, de la valeur effective et/ou de la phase de la valeur de mesure respective produite par le dispositif (30, 31, 32) de mesure.

7.  Agencement suivant l'une des revendications précédentes, **caractérisé en ce que**

    le signal (U1', U2', U3') de sortie est un signal analogique de tension, la valeur de mesure produite par le dispositif (30, 31, 32) de mesure est une valeur de mesure de tension, en particulier une valeur d'amplitude ou une valeur effective corrigée, et la valeur de mesure corrigée est une valeur de mesure de tension corrigée, en particulier une valeur d'amplitude ou effective corrigée que l'unité (40, 41, 42) de correction forme suivant

    $$Uk = f(Um)$$

    dans laquelle Uk désigne la valeur de mesure de tension corrigée et Um la valeur de mesure de tension produite par le dispositif (30, 31, 32) de mesure et f(Um) est au moins une fonction, qui dépend au moins également de la valeur de mesure de tension produite par le dispositif (30, 31, 32) de mesure.

8.  Agencement suivant l'une des revendications précédentes, **caractérisé en ce que**

    le signal (U1', U2', U3') de sortie est un signal analogique de tension, la valeur de mesure produite par le dispositif (30, 31, 32) de mesure est une valeur de mesure de phase et la valeur de mesure corrigée est une valeur de mesure de phase corrigée, que l'unité (40, 41, 42) de correction forme suivant

    $$\varphi k = f(U, \varphi m)$$

    dans laquelle $\varphi k$ désigne la valeur de mesure de phase corrigée et $\varphi m$ la valeur de mesure de phase produite par le dispositif (30, 31, 32) de mesure et f(U) est au moins une fonction, qui dépend au moins également du niveau du signal analogique de tension, en particulier de la valeur en amplitude ou effective du signal analogique de tension.

9.  Agencement suivant l'une des revendications précédentes, **caractérisé en ce que**

le signal (I1', I2', I3') de sortie est un signal analogique de courant, la valeur de mesure produite par le dispositif (30, 31, 32) de mesure est une valeur de mesure de courant et la valeur de mesure corrigée forme une valeur de mesure de courant corrigée, que l'unité (40, 41, 42) de correction forme suivant

$$Ik = f(Im)$$

dans laquelle Ik désigne la valeur de mesure du courant corrigée et Im la valeur de mesure du courant produite par le dispositif (30, 31, 32) de mesure et f(Im) est une fonction, qui dépend au moins également de la valeur de mesure de courant produite par le dispositif (30, 31, 32) de mesure.

10. Agencement suivant l'une des revendications précédentes, **caractérisé en ce que**

le signal (I1', I2', I3') est un signal de courant analogique, la valeur de la mesure produite par le dispositif (30, 31, 32) de mesure est une valeur de mesure de phase et la valeur de mesure corrigée est une valeur de phase corrigée, que l'unité (40, 41, 42) de correction forme suivant

$$\varphi k = f(I, \varphi m)$$

dans laquelle $\varphi k$ désigne la valeur de mesure de phase corrigée et $\varphi m$ la valeur de mesure de phase produite par le dispositif (30, 31, 32) de mesure et f(I) est une fonction, qui dépend au moins également du niveau du signal de courant analogique, en particulier de la valeur d'amplitude ou effective du signal de courant analogique.

11. Agencement suivant l'une des revendications précédentes, **caractérisé en ce que**
l'instruction de correction associée individuellement à l'unité de mesure prévoit la correction de la valeur de mesure du dispositif (30, 31, 32) de mesure en tenant compte d'un paramètre d'environnement, en particulier de la température ambiante respective de l'unité (20, 21, 22, 20U, 21U, 22U) de mesure.

12. Procédé pour faire fonctionner un agencement comprenant un dispositif (30, 31, 32) de mesure, qui mesure un signal (I1', I2', I3', U1', U2', U3') de sortie, donné par une unité (20, 21, 22, 20U, 21U, 22U) de mesure et décrivant une grandeur de fonctionnement d'une installation (10) technique, et produit une valeur de mesure,

- dans lequel l'agencement forme un appareil de protection ou de mesure pour le raccordement à une unité (20, 21, 22, 20U, 21U, 22U) analogique de mesure d'une installation de la haute, moyenne ou basse tension, ou du moins comprend également un tel appareil de protection de mesure,
- et dans lequel on corrige la valeur de mesure produite par le dispositif (30, 31, 32) de mesure suivant une indication de correction associée individuellement à l'unité de mesure et on produit une valeur de mesure corrigée, dans lequel la mesure de la correction, suivant l'indication de correction individuelle à l'unité de mesure, dépend de la valeur de mesure produite par le dispositif (30, 31, 32) de mesure, dans lequel la valeur de mesure corrigée décrit l'état électrique de l'installation de haute, moyenne ou basse tension,
- et dans lequel l'instruction de correction individuelle à l'unité de mesure a été déterminée à l'aide d'une courbe d'erreur ou d'une famille de courbes d'erreur mesurée pour l'unité (20, 21, 22, 20U, 21U, 22U) de mesure, qui quantifie, en fonction de la grandeur de fonctionnement, des erreurs provoquées par l'unité (20, 21, 22, 20U, 21U, 22U) de mesure dans le signal (I1', I2', I3', U1', U2', U3') de sortie, et
- par la correction de la valeur de mesure produite par le dispositif (30, 31, 32) de mesure, on compense ou du moins on réduit, au moyen de l'instruction de correction, l'erreur provoquée par l'unité (20, 21, 22, 20U, 21U, 22U) de mesure,

**caractérisé en ce que**
- l'instruction de correction contient une fonction ou une famille de fonctions inverse ou complémentaire de la courbe d'erreur ou de la famille de courbes d'erreur mesurée ou est formée par une fonction ou une famille de fonctions inverse ou complémentaire de ce genre, dans lequel l'instruction de correction dépend également du niveau d'une autre grandeur de fonctionnement d'une installation (10) technique.

# FIG 1

# FIG 2

## FIG 3

## FIG 4

## FIG 5

## FIG 6

## FIG 7

## FIG 8

## FIG 9

## FIG 10

# FIG 11

# FIG 12

# FIG 13

# FIG 14

10

L3    L2    L1

(20)  I1' → [30]  φim1 → [40]  φik1 →

I3   I2   I1

(21)  I2' → [31]  φim2 → [41]  φik2 →

(22)  I3' → [32]  φim3 → [42]  φik3 →

# FIG 15

# FIG 16